# EUROPEAN PATENT SPECIFICATION

(11) **EP 3 050 462 B1**
(45) Date of publication and mention of the grant of the patent: **14.03.2018**
(21) Application number: 15152781.9
(22) Date of filing: 28.01.2015
(51) Int. Cl.: A47B 88/40, H05K 7/14

(54) **Slide rail assembly and bracket device thereof**
Schienenanordnung und Haltevorrichtung dafür
Ensemble rail coulissant et son dispositif de support

(43) Date of publication of application: 03.08.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- CN-A- 103 892 594
- US-A1- 2001 040 142
- US-A1- 2002 074 914

## Description

### Field of the Invention

The present invention relates to a slide rail and more particularly to a slide rail assembly with a bracket device adaptive to racks of different depths.

### Background of the Invention

Generally, a slide rail assembly in a rack-based server system is mounted with a bracket at the front as well as at the rear in order to be mounted to two posts of a rack via the two brackets. As the distance between the two posts may vary with system design or due to other factors, adjustable brackets are in demand. U.S. Patent No. 8,028,965 B2 and U.S. Patent No. 8,721,012 B2, for example, disclose such adjustable brackets.

US 2002/074914 A1 discloses a slide rail assembly comprising a rail and a bracket device. The bracket device comprises a first and a second supporting bracket. The rail is connected to the first supporting bracket. The first supporting bracket is movably connected to the second supporting bracket.
According to CN 103892594 A, a slide rail assembly is disclosed comprising a rail and a bracket device. The bracket device comprises a first, a second and a third supporting bracket, wherein the first supporting bracket is connected to the rail. The second supporting bracket is connected to the rail, too and the third supporting bracket is movably connected to the first and the second supporting brackets.

US 2001/0040142 A1 discloses a slide rail assembly according to the preamble of claim 1. The slide rail assembly comprises a rail and a bracket device applicable to the rail. The bracket device comprises a first supporting bracket connected to the rail of the slide and assembly and a second supporting bracket movably connected the first supporting bracket and a third supporting bracket movably connected to the second supporting bracket. Further the bracket device comprises a mounting bracket movably connected to the second supporting bracket. Additionally, the mounting bracket comprises a side portion, a first bent portion and the second bent portion, respectively connected to two opposite sides opposite sides of the side plate. A bracket passage is defined between the first bent portion and second bent portion. Moreover, the side plate of the mounting bracket comprises a first blocking portion and a second blocking portion. A slot is defined between the first blocking portion of the mounting bracket in the second blocking portion of the mounting bracket. The bracket device further comprises a connecting member passing through the slot of the side plate of the mounting bracket and connected to the third supporting bracket. Therefore the mounting brackets can be adjusted relative to the second supporting bracket to a limited extent by the length of the slot.

Therefore, it is an object of the present invention to provide a solution for a slide rail assembly providing an increased adjustment range of the mounting bracket.

### Summary of the Invention

This object is solved by a slide rail assembly according to claim 1..

The slide rail assembly comprises a rail and a bracket device applicable to the rail. The bracket device comprises a first supporting bracket connected to the rail of the slide rail assembly. The bracket device further comprises a second supporting bracket movably connected to the first supporting bracket and a third supporting bracket movably connected to the second supporting bracket. A mounting bracket is movably connected to the third supporting bracket and comprises a side plate, a first bent portion and a second bent portion respectively connected to two opposite sides of the side plate, and a bracket passage, which is defined between the first bent portion and the second bent portion, wherein the side plate of the mounting bracket further comprises a first blocking portion and a second blocking portion, and a slot which is defined between the first blocking portion of the mounting bracket. The second blocking portion of the mounting bracket, and the bracket device further comprises a connecting member passing through the slot of the side plate of the mounting bracket and which is connected to the third supporting bracket, allowing the mounting bracket to be adjusted relative to the third supporting bracket to a limited extent by the length of the slot. The rail is inserted in the bracket passage such that the mounting bracket is mounted to the rail and displaceable relative to the rail. The rail further includes a first blocking portion and a second blocking portion, and a slot which is defined between the first blocking portion of the rail and the second blocking portion of the rail. The bracket device further includes a protruding member passing through the slot of the rail and being connected to the second supporting bracket, allowing the second supporting bracket to be adjusted relative to the first supporting bracket to a limited extend defined by the length of the slot. The second supporting bracket comprises a blocking section. The third supporting bracket comprises a blocking section corresponding to the blocking section of the second supporting bracket, so that during an adjustment, the blocking section of the third supporting bracket is pressed against the blocking section of the second supporting bracket and drives the second supporting bracket into displacement.

According to another aspect of the present invention, a slide rail assembly includes: a rail having two portions; and a bracket device and another bracket device respectively mounted to the two portions of the rail so that the slide rail assembly can be mounted to a first post and a second post of a rack. The bracket device includes a first supporting bracket, a second supporting bracket, a third supporting bracket, and a mounting bracket. The first supporting bracket is connected to the rail of the slide rail assembly. The second supporting bracket is movably connected to the first supporting bracket. The third supporting bracket is movably connected to the second supporting bracket. The mounting bracket is movably connected to the third supporting bracket and includes a side plate, an end plate substantially perpendicularly connected to the side plate, and at least one mounting member connected to the end plate.

According to yet another aspect of the present invention, a bracket device applicable to a rail of a slide rail assembly is provided, wherein the rail includes an upper wall, a lower wall, and a middle wall extending and connected between the upper wall of the rail and the lower wall of the rail. The bracket device includes a first supporting bracket, a second supporting bracket, a third supporting bracket, and a mounting bracket. The first supporting bracket is connected to the middle wall of the rail and includes an upper wall, a lower wall, a middle wall extending and connected between the upper wall of the first supporting bracket and the lower wall of the first supporting bracket, a first bent portion bent downward from the upper wall of the first supporting bracket, and a second bent portion bent upward from the lower wall of the first supporting bracket and corresponding to the first bent portion of the first supporting bracket. The upper wall, the lower wall, the middle wall, the first bent portion, and the second bent portion of the first supporting bracket jointly define a supporting passage. The second supporting bracket is located in the supporting passage of the first supporting bracket and includes an upper wall, a lower wall, a middle wall extending and connected between the upper wall of the second supporting bracket and the lower wall of the second supporting bracket, a first bent portion bent downward from the upper wall of the second supporting bracket, and a second bent portion bent upward from the lower wall of the second supporting bracket. The upper wall of the second supporting bracket is located in the supporting passage of the first supporting bracket and is adjacent to the upper wall of the first supporting bracket. The lower wall of the second supporting bracket is located in the supporting passage of the first supporting bracket and is adjacent to the lower wall of the first supporting bracket. The middle wall of the second supporting bracket is located in the supporting passage of the first supporting bracket and is adjacent to the middle wall of the first supporting bracket. The upper wall, the lower wall, the middle wall, the first bent portion, and the second bent portion of the second supporting bracket jointly define a supporting passage. The third supporting bracket is located in the supporting passage of the second supporting bracket and includes a first bent portion, a second bent portion, and a middle wall extending and connected between the first bent portion of the third supporting bracket and the second bent portion of the third supporting bracket. The first bent portion of the third supporting bracket is located in the supporting passage of the second supporting bracket and is adjacent to the upper wall of the second supporting bracket. The second bent portion of the third supporting bracket is located in the supporting passage of the second supporting bracket and is adjacent to the lower wall of the second supporting bracket. The mounting bracket includes a side plate adjacent to the middle wall of the third supporting bracket, an upper wall and a lower wall respectively connected to two opposite sides of the side plate, a first bent portion bent downward from the upper wall of the mounting bracket, and a second bent portion bent upward from the lower wall of the mounting bracket. The side plate, the upper wall, and the lower wall of the mounting bracket jointly define a receiving space for receiving the first supporting bracket, the second supporting bracket, and the third supporting bracket. A bracket passage in which the rail can be inserted is defined between the first bent portion of the mounting bracket and the second bent portion of the mounting bracket. The first bent portion of the mounting bracket corresponds to the upper wall of the rail while the second bent portion of the mounting bracket corresponds to the lower wall of the rail.

In some embodiments of any of the above aspects, the rail of the slide rail assembly further includes a side, and the first supporting bracket is connected to the side of the rail of the slide rail assembly.

One of the advantageous features of implementing the present invention is that the bracket device of the slide rail assembly can adapt to racks of various depths.

### Brief Description of the Drawings

The invention as well as a preferred mode of use and the advantages thereof will be best understood by referring to the following detailed description of some illustrative embodiments in conjunction with the accompanying drawings, in which:
FIG. 1 is a schematic perspective view of the slide rail assembly in an embodiment of the present invention, wherein the slide rail assembly includes bracket devices;
FIG. 2 is a schematic exploded view of the bracket device in an embodiment of the present invention;
FIG. 3 is a schematic assembled sectional view of the bracket device in an embodiment of the present invention;
FIG. 4 is a schematic sectional view taken along line 4-4 in FIG. 1;
FIG. 5 schematically shows how the slide rail assembly in an embodiment of the present invention is mounted to a rack via the bracket devices;
FIG. 6A is a schematic drawing in which the mounting bracket in an embodiment of the present invention is at a first position relative to the rail of the slide rail assembly;
FIG. 6B is a schematic drawing in which the mounting bracket in FIG. 6A has been adjusted (i.e., displaced) to a second position relative to the rail of the slide rail assembly;
FIG. 6C is a schematic drawing in which the mounting bracket in FIG. 6A has been adjusted (i.e., displaced) to a third position relative to the rail of the slide rail assembly;
FIG. 6D is a schematic drawing in which the mounting bracket in FIG. 6A has been adjusted (i.e., displaced) to a fourth position relative to the rail of the slide rail assembly; and
FIG. 7 schematically shows how the slide rail assembly in FIG. 5 is mounted to another rack via the bracket devices.

### Detailed Description of the Invention

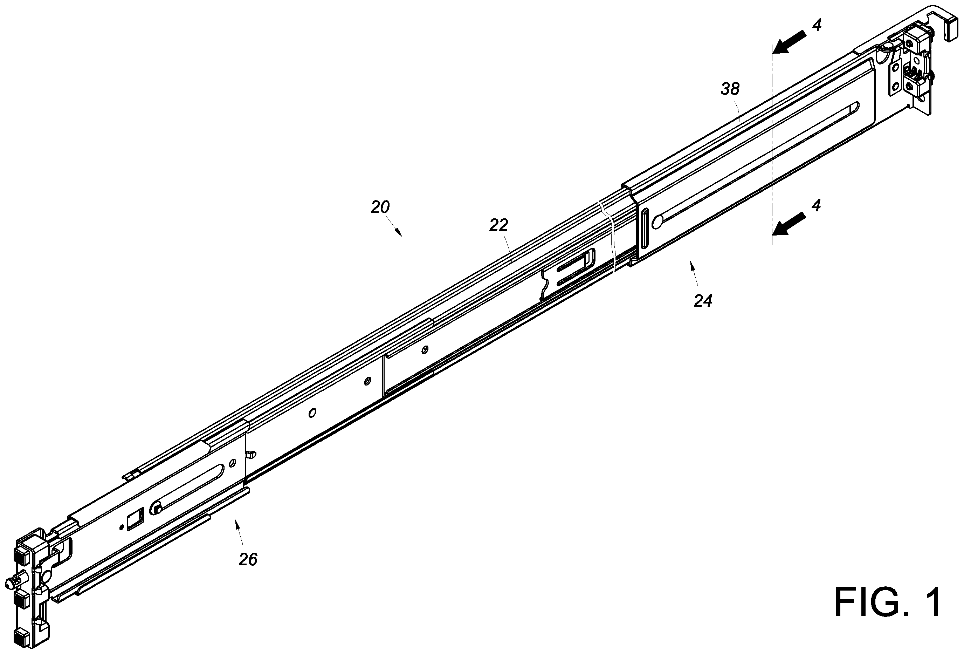

Referring to FIG. 1, the slide rail assembly 20 in an embodiment of the present invention includes a rail 22. The rail 22 has two portions (e.g., a front portion and a rear portion) which are mounted with a bracket device 24 and a bracket device 26 respectively. Hereinafter, the bracket device 24 is detailed to illustrate the features of the preferred embodiments of the present invention.

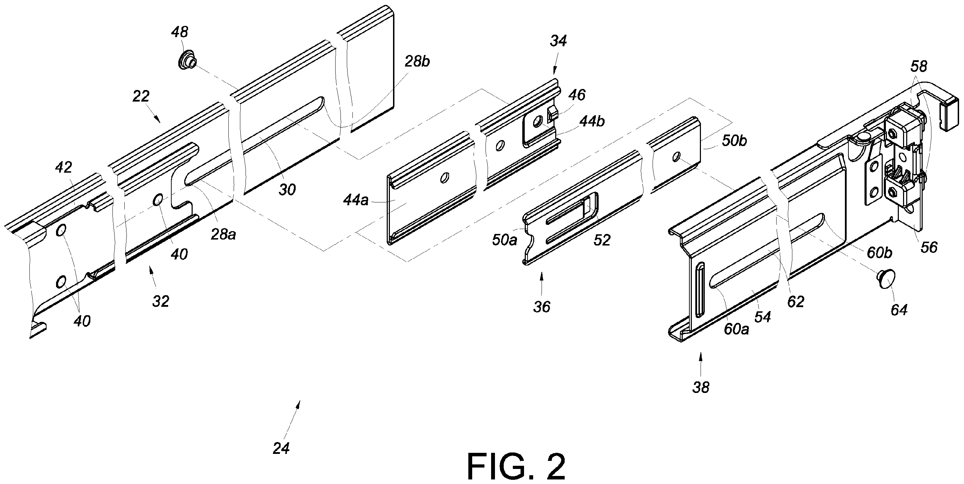

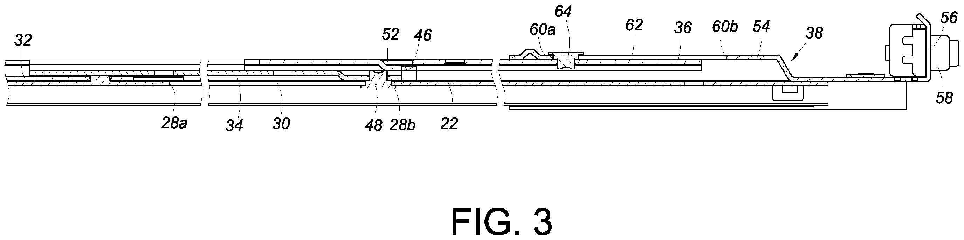

In a preferred embodiment as shown in FIG. 2 and FIG. 3, the rail 22 includes a first blocking portion 28a and a second blocking portion 28b, and a slot 30 is defined between the first blocking portion 28a and the second blocking portion 28b. The bracket device 24 includes a first supporting bracket 32, a second supporting bracket 34, a third supporting bracket 36, and a mounting bracket 38.

The first supporting bracket 32 is fixedly connected to the rail 22. For instance, the first supporting bracket 32 is fixedly connected to a side 42 (e.g., the rear side) of the rail 22 by a plurality of positioning elements 40 and is adjacent to the first blocking portion 28a of the rail 22. As the first supporting bracket 32 is fixedly connected to the rail 22, the first supporting bracket 32 can be viewed as a part of the rail 22. It is also feasible to connect the first supporting bracket 32 to the rail 22 by other connecting means such as soldering, threaded connection, or mechanical engagement. The present invention imposes no limitations in this respect.

The second supporting bracket 34 is movably connected to the first supporting bracket 32. The second supporting bracket 34 includes a first portion 44a, a second portion 44b opposite the first portion 44a, and a blocking section 46 located between the first portion 44a and the second portion 44b. The first portion 44a is movably connected to the first supporting bracket 32. The second portion 44b corresponds to the slot 30 of the rail 22 and includes a protruding member 48. The protruding member 48 can be formed with the second portion 44b or, as in this embodiment, be a separate component. A portion of the protruding member 48 passes through the slot 30 of the rail 22 and is connected to the second portion 44b such that the remaining portion of the protruding member 48 is limited between the first blocking portion 28a and the second blocking portion 28b of the rail 22. This allows the second supporting bracket 34 to be adjusted (i.e., displaced) relative to the first supporting bracket 32 to a limited extent defined by the length of the slot 30. Preferably, the blocking section 46 is adjacent to the second portion 44b.

The third supporting bracket 36 is movably connected to the second supporting bracket 34. The third supporting bracket 36 includes a first portion 50a, a second portion 50b opposite the first portion 50a, and a blocking section 52 located between the first portion 50a and the second portion 50b. The blocking section 52 of the third supporting bracket 36 corresponds in position to the blocking section 46 of the second supporting bracket 34.

The mounting bracket 38 is movably connected to the third supporting bracket 36. The mounting bracket 38 includes a side plate 54, an end plate 56 substantially perpendicularly connected to the side plate 54, and at least one mounting member 58 connected to the end plate 56. In this embodiment, two mounting members 58 are provided by way of example. In a preferred embodiment, the side plate 54 further includes a first blocking portion 60a and a second blocking portion 60b, and a slot 62 is defined between the first blocking portion 60a and the second blocking portion 60b.

It is worth mentioning that the third supporting bracket 36 includes a connecting member 64. The connecting member 64 can be formed with the third supporting member 36 or, as in this embodiment, be a separate component. A portion of the connecting member 64 passes through the slot 62 of the side plate 54 and is connected to the third supporting bracket 36 such that the remaining portion of the connecting member 64 is limited between the first blocking portion 60a and the second blocking portion 60b of the side plate 54. This allows the mounting bracket 38 to be adjusted (i.e., displaced) relative to the third supporting bracket 36 to a limited extent defined by the length of the slot 62.

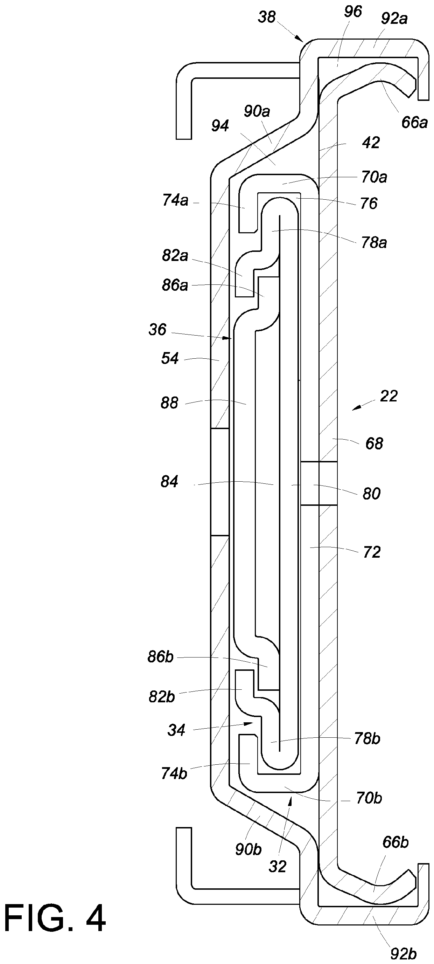

Referring to FIG. 4, the rail 22 further includes an upper wall 66a, a lower wall 66b, and a middle wall 68 extending and connected between the upper wall 66a and the lower wall 66b.

The first supporting bracket 32 includes an upper wall 70a, a lower wall 70b, a middle wall 72 extending and connected between the upper wall 70a and the lower wall 70b, a first bent portion 74a bent downward from the upper wall 70a, and a second bent portion 74b bent upward from the lower wall 70b and corresponding to the first bent portion 74a. The upper wall 70a, the lower wall 70b, the middle wall 72, the first bent portion 74a, and the second bent portion 74b jointly define a supporting passage 76. The first supporting bracket 32 is fixedly connected to the side 42 of the middle wall 68 of the rail 22 through the middle wall 72.

The second supporting bracket 34 is located in the supporting passage 76 of the first supporting bracket 32. The second supporting bracket 34 includes an upper wall 78a, a lower wall 78b, a middle wall 80 extending and connected between the upper wall 78a and the lower wall 78b, a first bent portion 82a bent downward from the upper wall 78a, and a second bent portion 82b bent upward from the lower wall 78b and corresponding to the first bent portion 82a. The upper wall 78a, the lower wall 78b, the middle wall 80, the first bent portion 82a, and the second bent portion 82b jointly define a supporting passage 84. The upper wall 78a is further bent backward and pressed against the middle wall 80 at a position adjacent to an upper part of the middle wall 80, is located in the supporting passage 76 of the first supporting bracket 32 and adjacent to the upper wall 70a, and thus forms an upper support. The lower wall 78b is further bent backward and pressed against the middle wall 80 at a position adjacent to a lower part of the middle wall 80, is located in the supporting passage 76 of the first supporting bracket 32 and adjacent to the lower wall 70b, and thus forms a lower support. The middle wall 80 is located in the supporting passage 76 of the first supporting bracket 32 and adjacent to the middle wall 72 and thus forms a middle support.

The third supporting bracket 36 is located in the supporting passage 84 of the second supporting bracket 34. The third supporting bracket 36 includes a first bent portion 86a, a second bent portion 86b, and a middle wall 88 extending and connected between the first bent portion 86a and the second bent portion 86b. The first bent portion 86a is bent from the middle wall 88 and turned upward, is located in the supporting passage 84 of the second supporting bracket 34 and adjacent to the upper wall 78a, and thus forms an upper support. The second bent portion 86b is bent from the middle wall 88 and turned downward, is located in the supporting passage 84 of the second supporting bracket 34 and adjacent to the lower wall 78b, and thus forms a lower support. The middle wall 88 is adjacent to the side plate 54 of the mounting bracket 38 (in other words, the side plate 54 of the mounting bracket 38 is adjacent to the middle wall 88 of the third supporting bracket 36) and forms a middle support.

The mounting bracket 38 includes an upper wall 90a and a lower wall 90b respectively connected to two opposite sides of the side plate 54, a first bent portion 92a bent downward from the upper wall 90a, and a second bent portion 92b bent upward from the lower wall 90b and corresponding to the first bent portion 92a. The side plate 54, the upper wall 90a, and the lower wall 90b jointly define a receiving space 94 for receiving the first supporting bracket 32, the second supporting bracket 34, and the third supporting bracket 36. Defined between the first bent portion 92a and the second bent portion 92b is a bracket passage 96 in which the rail 22 can be inserted. More particularly, the first bent portion 92a is configured to hold the upper wall 66a of the rail 22 and hence forms an upper support, and the second bent portion 92b is configured to hold the lower wall 66b of the rail 22 and hence forms a lower support. Thus, displacement of the mounting bracket 38 relative to the rail 22 can be carried out in a well-supported manner, and the first supporting bracket 32, the second supporting bracket 34, and/or the third supporting bracket 36 can be adjusted (i.e., displaced) relative to one another also in a well-supported manner.

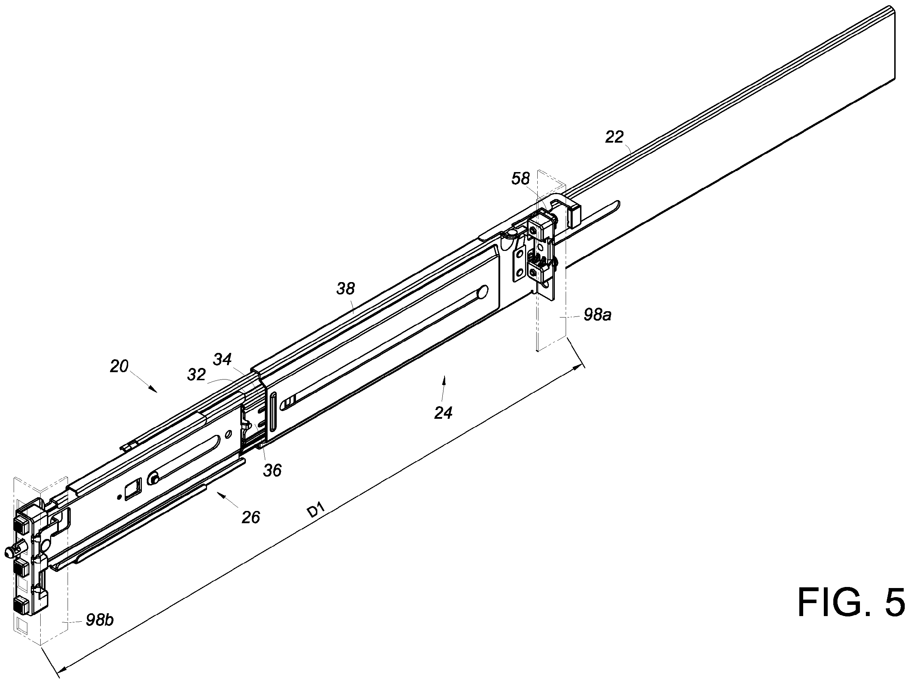

FIG. 5 shows how the slide rail assembly 20 is mounted to a first post 98a and a second post 98b of a rack via the bracket device 24 and the bracket device 26. More specifically, the bracket device 26 can be mounted to the second post 98b when a first distance D1 exists between the first post 98a and the second post 98b, and the mounting bracket 38 of the bracket device 24 can be adjusted to adapt the distance between the mounting bracket 38 of the bracket device 24 and the bracket device 26 to the first distance D1. The mounting bracket 38 is mounted to the first post 98a via the mounting members 58.

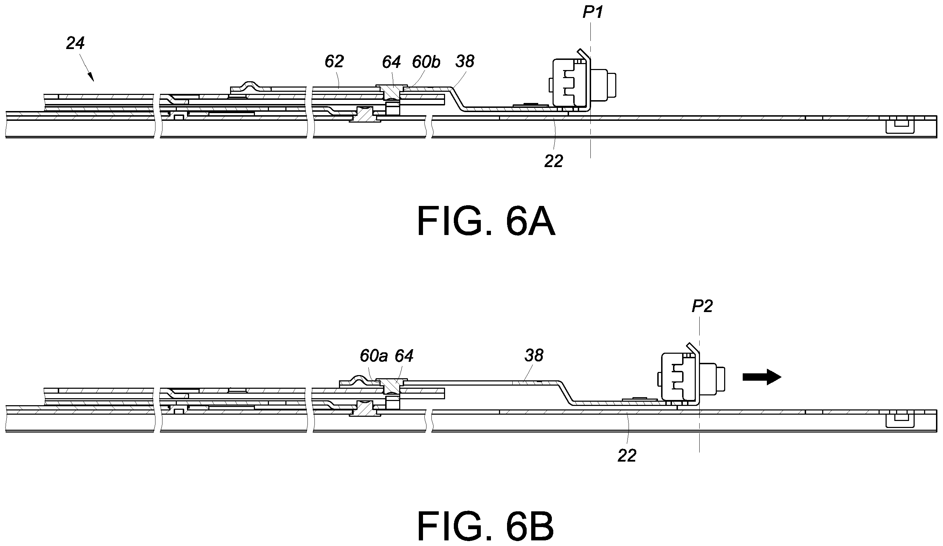

In FIG. 6A, the mounting bracket 38 of the bracket device 24 is at a first position P1 relative to the rail 22, with the connecting member 64 located in the slot 62 of the mounting bracket 38 and adjacent to the second blocking portion 60b.

FIG. 6B shows that the mounting bracket 38 can be adjusted in the arrow-indicated direction from the first position P1 to a second position P2 relative to the rail 22 such that the first blocking portion 60a of the mounting bracket 38 is pressed against the connecting member 64.

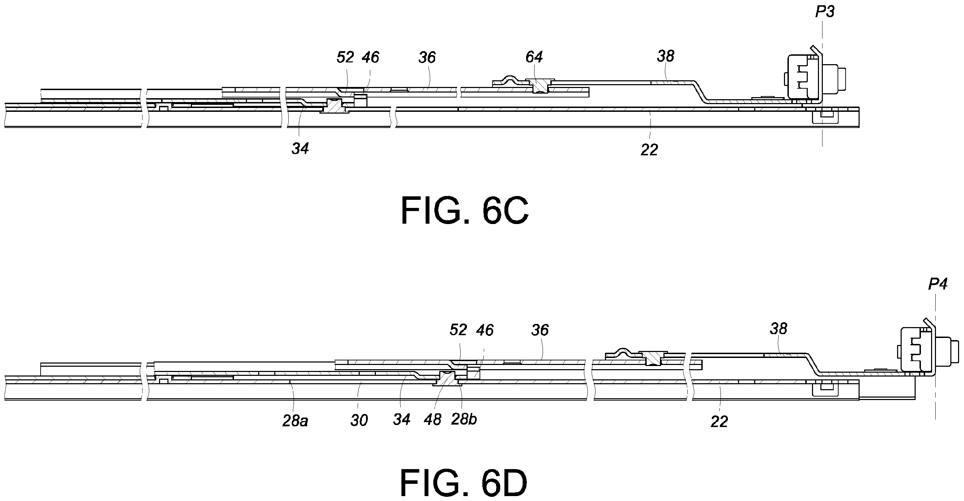

Referring to FIG. 6C, the mounting bracket 38 can be further adjusted according to the user's need and displaced from the second position P2 to a third position P3 relative to the rail 22 such that, with the connecting member 64 driving the third supporting bracket 36 into displacement, the blocking section 52 of the third supporting bracket 36 is pressed against the blocking section 46 of the second supporting bracket 34.

In FIG. 6D, the mounting bracket 38 has been further adjusted according to the user's need and displaced from the third position P3 to a fourth position P4 relative to the rail 22. During the adjustment, the blocking section 52 of the third supporting bracket 36 is pressed against the blocking section 46 of the second supporting bracket 34 and drives the second supporting bracket 34 into displacement. As a result, the protruding member 48 is driven by the second supporting bracket 34 to displace in the slot 30 of the rail 22 from the first blocking portion 28a to a position adjacent to the second blocking portion 28b.

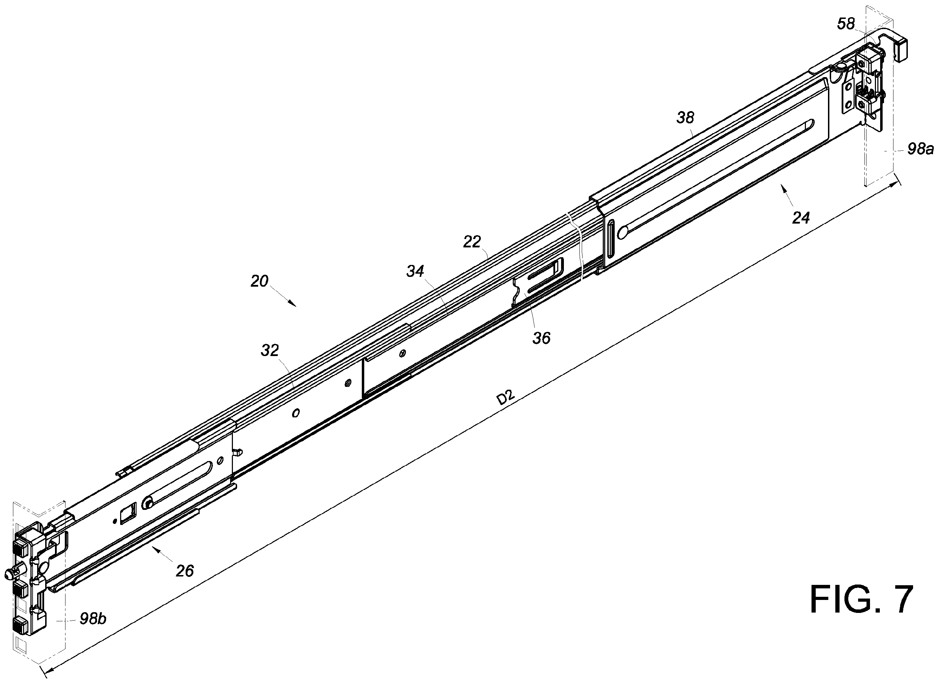

FIG. 7 shows that the bracket device 26 can be mounted to the second post 98b when a second distance D2 exists between the first post 98a and the second post 98b. As shown in the drawing, the mounting bracket 38 of the bracket device 24 has been adjusted to a position where the distance between the mounting bracket 38 of the bracket device 24 and the bracket device 26 is adapted to the second distance D2. It can be known from the above that the present embodiment can adapt to racks of different depths, thanks to the adjustability of the bracket device 24. In particular, the first supporting bracket 32, the second supporting bracket 34, the third supporting bracket 36, the rail 22, and the mounting bracket 38 continue to support one another when the bracket device 24 is adjusted to an extended state, thereby ensuring support for and hence stability of the extended bracket device 24.

While the present invention has been disclosed by the preferred embodiments described above, the embodiments are not intended to be restrictive of the present invention. The scope of patent protection sought by the applicant is defined by the appended claims.

## Claims

1. Slide rail assembly (20) comprising a rail (22) and a bracket device (24) applicable to the rail (22), the bracket device (24) comprising:
a first supporting bracket (32) connected to the rail (22) of the slide rail assembly (20);
a second supporting bracket (34) movably connected to the first supporting bracket (32);
a third supporting bracket (36) movably connected to the second supporting bracket (34); and
a mounting bracket (38) movably connected to the third supporting bracket (36) and comprising a side plate (54), a first bent portion (92a) and a second bent portion (92b) respectively connected to two opposite sides of the side plate (54), and a bracket passage (96), which is defined between the first bent portion (92a) and the second bent portion (92b), wherein
the side plate (54) of the mounting bracket (38) further comprises a first blocking portion (60a) and a second blocking portion (60b), and a slot (62), which is defined between the first blocking portion (60a) of the mounting bracket (38) and the second blocking portion (60b) of the mounting bracket (38); and the bracket device (24) further comprises a connecting member (64) passing through the slot (62) of the side plate (54) of the mounting bracket (38) and being connected to the third supporting bracket (36), allowing the mounting bracket (38) to be adjusted relative to the third supporting bracket (36) to a limited extent by the length of the slot (62)
**characterized in,**
**that** the rail (22) is inserted in the bracket passage (96) such that the mounting bracket (38) is mounted to the rail (22) and displaceable relative to the rail (22), and
**that** the rail (22) further includes a first blocking portion (28a) and a second blocking portion (28b), and a slot (30), which is defined between the first blocking portion (28a) of the rail (22) and the second blocking portion (28b) of the rail (22), and
**that** the bracket device (24) further includes a protruding member (48) passing through the slot (30) of the rail (22) and being connected to the second supporting bracket (34), allowing the second supporting bracket (34) to be adjusted relative to the first supporting bracket (32) to a limited extend defined by the length of the slot (30), and
**that** the second supporting bracket (34) comprises a blocking section (46), and that the third supporting bracket (36) comprises a blocking section (52) corresponding to the blocking section (46) of the second supporting bracket (34), so that during an adjustment, the blocking section (52) of the third supporting bracket (36) is pressed against the blocking section (46) of the second supporting bracket (34) and drives the second supporting bracket (34) into displacement.

2. Slide rail assembly (20) as claimed in claim 1, wherein the rail (22) of the slide rail assembly (20) further comprises a side (42), and the first supporting bracket (32) is connected to the side (42) of the rail (22) of the slide rail assembly (20).

3. Slide rail assembly (20) as claimed in claim 1, wherein the rail (22) comprises an upper wall (66a), a lower wall (66b), and a middle wall (68) extending and connected between the upper wall (66a) of the rail (22) and the lower wall (66b) of the rail (22),
wherein the first supporting bracket (32) is connected to the middle wall (68) of the rail (22) and comprises an upper wall (70a), a lower wall (70b), a middle wall (72) extending and connected between the upper wall (70a) of the first supporting bracket (32) and the lower wall (70b) of the first supporting bracket (32), a first bent portion (74a) bent downward from the upper wall (70a) of the first supporting bracket (32), and a second bent portion (74b) bent upward from the lower wall (70b) of the first supporting bracket (32) and corresponding to the first bent portion (74a) of the first supporting bracket (32), wherein the upper wall (70a), the lower wall (70b), the middle wall (72), the first bent portion (74a), and the second bent portion (74b) of the first supporting bracket (32) jointly define a supporting passage (76);
wherein the second supporting bracket (34) is located in the supporting passage (76) of the first supporting bracket (32) and comprises an upper wall (78a), a lower wall (78b), a middle wall (80) extending and connected between the upper wall (78a) of the second supporting bracket (34) and the lower wall (78b) of the second supporting bracket (34), a first bent portion (82a) bent downward from the upper wall (78a) of the second supporting bracket (34), and a second bent portion (82b) bent upward from the lower wall (78b) of the second supporting bracket (34), wherein the upper wall (78a) of the second supporting bracket (34) is located in the supporting passage (76) of the first supporting bracket (32) and adjacent to the upper wall (70a) of the first supporting bracket (32), the lower wall (78b) of the second supporting bracket (34) is located in the supporting passage (76) of the first supporting bracket (32) and adjacent to the lower wall (70b) of the first supporting bracket (32), the middle wall (80) of the second supporting bracket (34) is located in the supporting passage (76) of the first supporting bracket (32) and adjacent to the middle wall (72) of the first supporting bracket (32), and the upper wall (78a), the lower wall (78b), the middle wall (80), the first bent portion (82a), and the second bent portion (82b) of the second supporting bracket (34) jointly define a supporting passage (84);
wherein the third supporting bracket (36) is located in the supporting passage (84) of the second supporting bracket (34) and comprises a first bent portion (86a), a second bent portion (86b), and a middle wall (88) extending and connected between the first bent portion (86a) of the third supporting bracket (36) and the second bent portion (86b) of the third supporting bracket (36), wherein the first bent portion (86a) of the third supporting bracket (36) is located in the supporting passage (84) of the second supporting bracket (34) and adjacent to the upper wall (78a) of the second supporting bracket (34), and the second bent portion (86b) of the third supporting bracket (36) is located in the supporting passage (84) of the second supporting bracket (34) and adjacent to the lower wall (78b) of the second supporting bracket (34); and
wherein the mounting bracket (38) comprises the side plate (54) adjacent to the middle wall (88) of the third supporting bracket (36), and an upper wall (90a) and a lower wall (90b) respectively connected to two opposite sides of the side plate (54), wherein the first bent portion (92a) is bent downward from the upper wall (90a) of the mounting bracket (38); the second bent portion (92b) is bent upward from the lower wall (90b) of the mounting bracket (38); the side plate (54), the upper wall (90a), and the lower wall (90b) of the mounting bracket (38) jointly define a receiving space (94) for receiving the first supporting bracket (32), the second supporting bracket (34), and the third supporting bracket (36);the first bent portion (92a) of the mounting bracket (38) corresponds to the upper wall (66a) of the rail (22); and the second bent portion (92b) of the mounting bracket (38) corresponds to the lower wall (66b) of the rail (22).

4. Slide rail assembly (20) as claimed in claim 3, wherein the middle wall (68) of the rail (22) of the slide rail assembly (20) further comprises a side (42), and the first supporting bracket (32) is connected to the side (42) of the middle wall (68) of the rail (22).

5. Slide rail assembly (20) as claimed in any of claims 1-4, wherein the mounting bracket (38) further comprises an end plate (56) substantially perpendicularly connected to the side plate (54), and at least one mounting member (58) connected to the end plate (56).

6. Slide rail assembly (20) as claimed in any of claims 1-5, comprising another bracket device (26), wherein the rail (22) has two portions, and the bracket device (24) and the bracket device (26) are respectively mounted to the two portions of the rail (22) so that the slide rail assembly (20) is mountable to a first post (98a) and a second post (98b) of a rack.

## Patentansprüche

1. Eine Laufschienenmontage (20), umfassend eine Schiene (22) und eine Halterungsvorrichtung (24), die an der Schiene (22) befestigt werden kann; die Halterungsvorrichtung (24) die folgenden Komponenten umfasst:
eine erste Stützklammer (32), die an der Schiene (22) der Laufschienenmontage (20) befestigt ist;
eine zweite Stützklammer (34), die beweglich an der ersten Stützklammer (32) befestigt ist;
eine dritte Stützklammer (36), die beweglich an der zweiten Stützklammer (34) befestigt ist; und
eine Halterung (38), die beweglich an der dritten Stützklammer (36) befestigt ist und eine Seitenplatte (54), einen ersten gebogenen Teil (92a) und einen zweiten gebogenen Teil (92b), die je an die beiden gegenüberliegenden Seiten der Seitenplatte (54) befestigt sind, umfasst; ein Halterungsdurchgang (96), der zwischen dem ersten gebogenen Teil (92a) und dem zweiten gebogenen Teil (92b) definiert ist; worin
die Seitenplatte (54) der Halterung (38) weiter einen ersten Sperrteil (60a) und einen zweiten Sperrteil (60b) umfasst und ein Langloch (62) aufweist, das zwischen dem ersten Sperrteil (60a) der Halterung (38) und dem zweiten Sperrteil (60b) der Halterung (38) gebildet ist; die Halterungsvorrichtung (24) weiter ein Verbindungsglied (64) umfasst, das durch das Langloch (62) der Seitenplatte (54) der Halterung (38) ragt und an der dritten Stützklammer (36) befestigt ist, so dass die an die dritte Stützklammer (36) einzustellende Halterung (38) bis zu einem begrenzten Ausmass in der Länge des Langlochs (62) verschoben werden kann;
**dadurch gekennzeichnet,**
**dass** die Schiene (22) in den Halterungsdurchgang (96) so eingeführt ist, dass die Halterung (38) an die Schiene (22) montiert wird und an der Schiene (22) verschiebbar ist; und
**dass** die Schiene (22) weiter aus einem ersten Sperrteil (28a) und einem zweiten Sperrteil (28b) besteht und ein Langloch (30) aufweist, das zwischen dem ersten Sperrteil (28a) der Schiene (22) und dem zweiten Sperrteil (28b) der Schiene (22) gebildet ist; und
**dass** die Halterungsvorrichtung (24) weiter aus einem vorstehenden Glied (48) besteht, dass durch das Langloch (30) der Schiene (22) ragt und an der zweiten Stützklammer (34) befestigt ist, so dass die an der ersten Stützklammer (32) einzustellende zweite Stützklammer (34) bis zu einem begrenzten Ausmass in der Länge des Langlochs (30) verschoben werden kann; und
**dass** die zweite Stützklammer (34) einen Sperrabschnitt (46) umfasst, wobei die dritte Stützklammer (36) einen Sperrabschnitt (52) in Übereinstimmung mit dem Sperrabschnitt (46) der zweiten Stützklammer (34) umfasst, so dass bei einer Einstellung der Sperrabschnitt (52) der dritten Stützklammer (36) an den Sperrabschnitt (46) der zweiten Stützklammer (34) gedrückt wird und die zweite Stützklammer (34) zum Verschieben antreibt.

2. Die Laufschienenmontage (20) nach Anspruch 1, worin die Schiene (22) der Laufschienenmontage (20) weiter eine Fläche (42) aufweist und die erste Stützklammer (32) an dieser Fläche (42) der Schiene (22) der Laufschienenmontage (20) befestigt ist.

3. Die Laufschienenmontage (20) nach Anspruch 1, worin die Schiene (22) eine obere Wand (66a), eine untere Wand (66b) und eine Mittenwand (68), die sich zwischen der oberen Wand (66a) der Schiene (22) und der unteren Wand (66b) der Schiene (22) erstreckt und zwischen diesen gebildet ist, umfasst,
worin die erste Stützklammer (32) an der Mittenwand (68) der Schiene (22) befestigt ist und eine obere Wand (70a), eine untere Wand (70b), eine Mittenwand (72), die sich zwischen der oberen Wand (70a) der ersten Stützklammer (32) und der unteren Wand (70b) der ersten Stützklammer (32) erstreckt und zwischen diesen gebildet ist, einen ersten gebogenen Teil (74a), der von der oberen Wand (70a) der ersten Stützklammer (32) nach unten gebogen ist, und einem zweiten gebogenen Teil (74b), der von der unteren Wand (70b) der ersten Stützklammer (32) und in Übereinstimmung mit dem ersten gebogenen Teil (74a) der ersten Stützklammer (32) nach oben gebogen ist, umfasst; worin die obere Wand (70a), die untere Wand (70b), die Mittenwand (72), der erste gebogene Teil (74a) und der zweite gebogene Teil (74b) der ersten Stützklammer (32) zusammen eine Unterstützungsleitung (76) definieren;
worin die zweite Stützklammer (34) in der Unterstützungsleitung (76) der ersten Stützklammer (32) angeordnet ist und eine obere Wand (78a), eine untere Wand (78b), eine Mittenwand (80), die sich zwischen der oberen Wand (78a) der zweiten Stützklammer (34) und der unteren Wand (78b) der zweiten Stützklammer (34) erstreckt und zwischen diesen gebildet ist, einen ersten gebogenen Teil (82a), der von der oberen Wand (78a) der zweiten Stützklammer (34) nach unten gebogen ist, und einen zweiten gebogenen Teil (82b), der von der unteren Wand (78b) der zweiten Stützklammer (34) nach oben gebogen ist, umfasst; worin die obere Wand (78a) der zweiten Stützklammer (34) in der Unterstützungsleitung (76) der ersten Stützklammer (32) angeordnet ist und an die obere Wand (70a) der ersten Stützklammer (32) angrenzt; die untere Wand (78b) der zweiten Stützklammer (34) in der Unterstützungsleitung (76) der ersten Stützklammer (32) angeordnet ist und an die untere Wand (70b) der ersten Stützklammer (32) angrenzt; die Mittenwand (80) der zweiten Stützklammer (34) in der Unterstützungsleitung (76) der ersten Stützklammer (32) angeordnet ist und an die Mittenwand (72) der ersten Stützklammer (32) angrenzt; die obere Wand (78a), die untere Wand (78b), die Mittenwand (80), der erste gebogene Teil (82a) und der zweite gebogene Teil (82b) der zweiten Stützklammer (34) zusammen eine Unterstützungsleitung (84) definieren;
worin die dritte Stützklammer (36) in der Unterstützungsleitung (84) der zweiten Stützklammer (34) angeordnet ist und einen ersten gebogenen Teil (86a), einen zweiten gebogenen Teil (86b) und eine Mittenwand (88), die sich zwischen dem ersten gebogenen Teil (86a) der dritten Stützklammer (36) und dem zweiten gebogenen Teil (86b) der dritten Stützklammer (36) erstreckt und zwischen diesen gebildet ist, umfasst; worin der erste gebogene Teil (86a) der dritten Stützklammer (36) in der Unterstützungsleitung (84) der zweiten Stützklammer (34) angeordnet ist und an die obere Wand (78a) der zweiten Stützklammer (34) angrenzt; der zweite gebogene Teil (86b) der dritten Stützklammer (36) in der Unterstützungsleitung (84) der zweiten Stützklammer (34) angeordnet ist und an die untere Wand (78b) der zweiten Stützklammer (34) angrenzt; und
worin die Halterung (38) die Seitenplatte (54) umfasst, die an die Mittenwand (88) der dritten Stützklammer (36) angrenzt; eine obere Wand (90a) und eine untere Wand (90b) je an eine der gegenüberliegenden Seiten der Seitenplatte (54) befestigt ist; worin der erste gebogene Teil (92a) von der oberen Wand (90a) der Halterung (38) nach unten gebogen ist; der zweite gebogene Teil (92b) von der unteren Wand (90b) der Halterung (38) nach oben gebogen ist; die Seitenplatte (54), die obere Wand (90a) und die untere Wand (90b) der Halterung (38) zusammen eine Aufnahmekammer (94) zur Aufnahme der ersten Stützklammer (32), der zweiten Stützklammer (34) und der dritten Stützklammer (36) definieren; der erste gebogene Teil (92a) der Halterung (38) mit der oberen Wand (66a) der Schiene (22) in Übereinstimmung ist; der zweite gebogene Teil (92b) der Halterung (38) mit der unteren Wand (66b) der Schiene (22) in Übereinstimmung ist.

4. Die Laufschienenmontage (20) nach Anspruch 3, worin die Mittenwand (68) der Schiene (22) der Laufschienenmontage (20) weiter eine Fläche (42) aufweist; die erste Stützklammer (32) an die Fläche (42) der Mittenwand (68) der Schiene (22) befestigt ist.

5. Die Laufschienenmontage (20) nach einem der Ansprüche 1-4, worin die Halterung (38) weiter eine Endplatte (56) umfasst, die im Wesentlichen senkrecht zur Seitenplatte (54) befestigt ist; mindestens ein Montageelement (58) an der Endplatte (56) befestigt ist.

6. Die Laufschienenmontage (20) nach einem der Ansprüche 1-5, umfassend eine weitere Halterungsvorrichtung (26), worin die Schiene (22) aus zwei Teilen besteht, während die Halterungsvorrichtung (24) und die Halterungsvorrichtung (26) je an einem der zwei Teile der Schiene (22) montiert sind, so dass die Laufschienenmontage (20) an eine erste Stange (98a) und an eine zweite Stange (98b) eines Gestells montiert werden kann.

## Revendications

1. Ensemble de rail coulissant (20) comprenant un rail (22) et un dispositif de support (24) applicable au rail (22), le dispositif de support (24) **caractérisé par le fait qu'**il comprend :
un premier support (32) raccordé au rail (22) de l'ensemble de rail coulissant (20) ;
un deuxième support (34) raccordé de manière mobile au premier support (32) ;
un troisième support (36) raccordé de manière mobile au deuxième support (34) ; et
un support de montage (38) raccordé de manière mobile au troisième support (36) et comprenant une plaque latérale (54), une première partie incurvée (92a) et une seconde partie incurvée (92b) respectivement raccordées à deux côtés opposés de la plaque latérale (54), et un passage de support (96), qui est défini entre la première partie incurvée (92a) et la seconde partie incurvée (92b), **caractérisé par le fait que**
la plaque latérale (54) du support de montage (38) comprend en outre une première partie de blocage (60a) et une seconde partie de blocage (60b), et une encoche (62), qui est définie entre la première partie de blocage (60a) du support de montage (38) et la seconde partie de blocage (60b) du support de montage (38) ; et le dispositif de support (24) comprend en outre un élément de raccordement (64) passant à travers l'encoche (62) de la plaque latérale (54) du support de montage (38) et étant raccordé au troisième support (36), permettant l'ajustement du support de montage (38) par rapport au troisième support (36) de manière limitée par la longueur de l'encoche (62)
**caractérisé en ce que**,
le rail (22) est inséré dans le passage de support (96) de sorte que le support de montage (38) est monté sur le rail (22) et déplaçable par rapport au rail (22), et
le rail (22) comprend en outre une première partie de blocage (28a) et une seconde partie de blocage (28b), et une encoche (30), qui est définie entre la première partie de blocage (28a) du rail (22) et la seconde partie de blocage (28b) du rail (22), et
le dispositif de support (24) comprend en outre un élément saillant (48) passant à travers l'encoche (30) du rail (22) et étant raccordé au deuxième support (34), permettant l'ajustement du deuxième support (34) par rapport au premier support (32) de manière limitée défini par la longueur de l'encoche (30), et
le deuxième support (34) comprend une section de blocage (46), et le troisième support (36) comprend une section de blocage (52) correspondant à la section de blocage (46) du deuxième support (34), de sorte que lors d'un ajustement, la section de blocage (52) du troisième support (36) est pressée contre la section de blocage (46) du deuxième support (34) et entraîne le déplacement du deuxième support (34).

2. Ensemble de rail coulissant (20) selon la revendication 1, **caractérisé par le fait que** le rail (22) de l'ensemble de rail coulissant (20) comprend en outre un côté (42), et le premier support (32) est raccordé au côté (42) du rail (22) de l'ensemble de rail coulissant (20).

3. Ensemble de rail coulissant (20) selon la revendication 1, **caractérisé par le fait que** le rail (22) comprend une paroi supérieure (66a), une paroi inférieure (66b), et une paroi médiane (68) se prolongeant et raccordée entre la paroi supérieure (66a) du rail (22) et la paroi inférieure (66b) du rail (22),
le premier support (32) est raccordé à la paroi médiane (68) du rail (22) et comprend une paroi supérieure (70a), une paroi inférieure (70b), une paroi médiane (72) se prolongeant et raccordée entre la paroi supérieure (70a) du premier support (32) et la paroi inférieure (70b) du premier support (32), une première partie incurvée (74a) incurvée vers le bas à partir de la paroi supérieure (70a) du premier support (32), et une seconde partie incurvée (74b) incurvée vers le haut à partir de la paroi inférieure (70b) du premier support (32) et correspondant à la première partie incurvée (74a) du premier support (32), **caractérisé par le fait que** la paroi supérieure (70a), la paroi inférieure (70b), la paroi médiane (72), la première partie incurvée (74a), et la seconde partie incurvée (74b) du premier support (32) définissent conjointement un passage de support (76) ;
le deuxième support (34) est situé dans le passage de support (76) du premier support (32) et comprend une paroi supérieure (78a), une paroi inférieure (78b), une paroi médiane (80) se prolongeant et raccordée entre la paroi supérieure (78a) du deuxième support (34) et la paroi inférieure (78b) du deuxième support (34), une première partie incurvée (82a) incurvée vers le bas à partir de la paroi supérieure (78a) du deuxième support (34), et une seconde partie incurvée (82b) incurvée vers le haut à partir de la paroi inférieure (78b) du deuxième support (34), **caractérisé par le fait que** la paroi supérieure (78a) du deuxième support (34) est située dans le passage de support (76) du premier support (32) et adjacente à la paroi supérieure (70a) du premier support (32), la paroi inférieure (78b) du deuxième support (34) est située dans le passage de support (76) du premier support (32) et adjacente à la paroi inférieure (70b) du premier support (32), la paroi médiane (80) du deuxième support (34) est située dans le passage de support (76) du premier support (32) et adjacente à la paroi médiane (72) du premier support (32), et la paroi supérieure (78a), la paroi inférieure (78b), la paroi médiane (80), la première partie incurvée (82a), et la seconde partie incurvée (82b) du deuxième support (34) définissent conjointement un passage de support (84) ;
le troisième support (36) est situé dans le passage de support (84) du deuxième support (34) et comprend une première partie incurvée (86a), une seconde partie incurvée (86b), et une paroi médiane (88) se prolongeant et raccordée entre la première partie incurvée (86a) du troisième support (36) et la seconde partie incurvée (86b) du troisième support (36), **caractérisé par le fait que** la première partie incurvée (86a) du troisième support (36) est située dans le passage de support (84) du deuxième support (34) et adjacente à la paroi supérieure (78a) du deuxième support (34), et la seconde partie incurvée (86b) du troisième support (36) est située dans le passage de support (84) du deuxième support (34) et adjacente à la paroi inférieure (78b) du deuxième support (34) ; et
le support de montage (38) comprend la plaque latérale (54) adjacente à la paroi médiane (88) du troisième support (36), et une paroi supérieure (90a) et une paroi inférieure (90b) respectivement raccordées à deux côtés opposés de la plaque latérale (54), **caractérisé par le fait que** la première partie incurvée (92a) est incurvée vers le bas à partir de la paroi supérieure (90a) du support de montage (38) ; la seconde partie incurvée (92b) est incurvée vers le haut à partir de la paroi inférieure (90b) du support de montage (38) ; la plaque latérale (54), la paroi supérieure (90a), et la paroi inférieure (90b) du support de montage (38) définissent conjointement un espace de réception (94) pour recevoir le premier support (32), le deuxième support (34), et le troisième support (36) ; la première partie incurvée (92a) du support de montage (38) correspond à la paroi supérieure (66a) du rail (22) ; et la seconde partie incurvée (92b) du support de montage (38) correspond à la paroi inférieure (66b) du rail (22).

4. Ensemble de rail coulissant (20) selon la revendication 3, **caractérisé par le fait que** la paroi médiane (68) du rail (22) de l'ensemble de rail coulissant (20) comprend en outre un côté (42), et le premier support (32) est raccordé au côté (42) de la paroi médiane (68) du rail (22).

5. Ensemble de rail coulissant (20) selon l'une des revendications 1-4, **caractérisé par le fait que** le support de montage (38) comprend en outre une plaque d'extrémité (56) raccordée de manière substantiellement perpendiculaire à la plaque latérale (54), et au moins un élément de montage (58) raccordé à la plaque d'extrémité (56).

6. Ensemble de rail coulissant (20) selon l'une des revendications 1-5, **caractérisé par le fait qu'**il comprend un autre dispositif de support (26), le rail (22) présente deux parties, et le dispositif de support (24) et le dispositif de support (26) sont respectivement montés sur les deux parties du rail (22) de sorte que l'ensemble de rail coulissant (20) est montable sur un premier montant (98a) et un second montant (98b) d'un rack.
